(19) Europäisches Patentamt

European Patent Office

Office européen des brevets

(11) **EP 3 113 593 A1**

(12) **EUROPEAN PATENT APPLICATION**

(43) Date of publication:
**04.01.2017 Bulletin 2017/01**

(51) Int Cl.:
**H05K 7/20** (2006.01)     **F28D 1/053** (2006.01)

(21) Application number: **16177340.3**

(22) Date of filing: **30.06.2016**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br>Designated Validation States:<br>**MA MD**<br><br>(30) Priority: **02.07.2015 US 201514790314** | (71) Applicant: **Schneider Electric IT Corporation West Kingston, RI 02892 (US)**<br><br>(72) Inventor: **LAZZARI, Matteo VI 36024 Nanto (IT)**<br><br>(74) Representative: **Hayden, Nicholas Mark et al Murgitroyd & Company Scotland House 165-169 Scotland Street Glasgow G5 8PL (GB)** |

(54) **COOLING SYSTEM AND METHOD HAVING MICRO-CHANNEL COIL WITH COUNTERCURRENT CIRCUIT**

(57)     A cooling unit includes a heat exchanger coil positioned coupled to a source of fluid. The heat exchanger includes at least one coil configured to face air being drawn through the heat exchanger. The at least one coil has a first pipe, a second pipe spaced from the first pipe, and a plurality of micro-channels disposed between and in fluid communication with the first pipe and the second pipe. Each of the first pipe, the second pipe and the plurality of micro-channels is configured to enable a countercurrent configuration between inner and outer fluids. Other embodiments of the cooling unit and methods of cooling are further disclosed.

FIG. 5

**Description**

BACKGROUND OF THE DISCLOSURE

1. Field of the Disclosure

The present disclosure relates generally to cooling systems used in a data center environment, and more particularly to a cooling system having a heat exchanger with micro-channel coils configured with a countercurrent circuit.

2. Discussion of Related Art

Equipment enclosures or racks for housing electronic equipment, such as data processing, networking and telecommunications equipment have been used for many years. Such racks are used to contain and to arrange the equipment in large data centers, as well as small wiring closets and equipment rooms. In certain embodiments, an equipment rack can be an open configuration and can be housed within a rack enclosure, although the enclosure may be included when referring to a rack. A standard rack typically includes front mounting rails to which multiple units of electronic equipment, such as servers, CPUs and telecommunication equipment, are mounted and stacked vertically within the rack. With the proliferation of the Internet, it is not uncommon for a data center to contain hundreds of these racks. Further, with the ever decreasing size of computer equipment, and in particular, computer servers and blades, the number of electrical devices mounted in each rack has been increasing, raising concerns about adequately cooling the equipment.

Heat produced by rack-mounted equipment can have adverse effects on the performance, reliability and useful life of the equipment components. In particular, rack-mounted equipment, housed within an enclosure, may be vulnerable to heat build-up and hot spots produced within the confines of the enclosure during operation. The amount of heat generated by a rack of equipment is dependent on the amount of electrical power drawn by equipment in the rack during operation. In addition, users of electronic equipment may add, remove, and rearrange rack-mounted components as their needs change and new needs develop.

In certain configurations, data centers have been cooled by computer room air conditioner ("CRAC") units that are positioned around the periphery of the data center room. Such cooling units can be configured to intake air from the fronts of the units and output cooler air upwardly toward the ceiling of the data center room. In other embodiments, the cooling units intake air from near the ceiling of the data center room and discharge cooler air under a raised floor for delivery to the fronts of the equipment racks. In general, such cooling units intake room temperature air (from about 72 °F to 95 °F) and discharge cold air (from about 75 °F to 55 °F), which is blown into the data center room and mixed with the room temperature air at or near the equipment racks. With perimetral units, the hot and/or cold aisle containments are used to avoid the mixing of hot and cold air within the data center in such a manner to increase the return of air temperature (to the CRAC) and reduce the mixing losses. The rack-mounted equipment typically cools itself by drawing air along a front side or air inlet side of a rack, drawing the air through its components, and subsequently exhausting the air from a rear or vent side of the rack.

One exemplary cooling unit is constituted by a box-shaped housing, which is opened at the top to receive a certain air flow rate and opened at the bottom to deliver the air flow to the servers. The housing typically supports a heat exchange coil to cool down the air entering the cooling unit, the fans to move the air flow, and one (or more) compressors when employing direct expansion units. Other devices that are needed to operate the cooling unit, such as pipes used to connect the heat exchange coil, a pan to collect condensate, and other components, are supported within the housing.

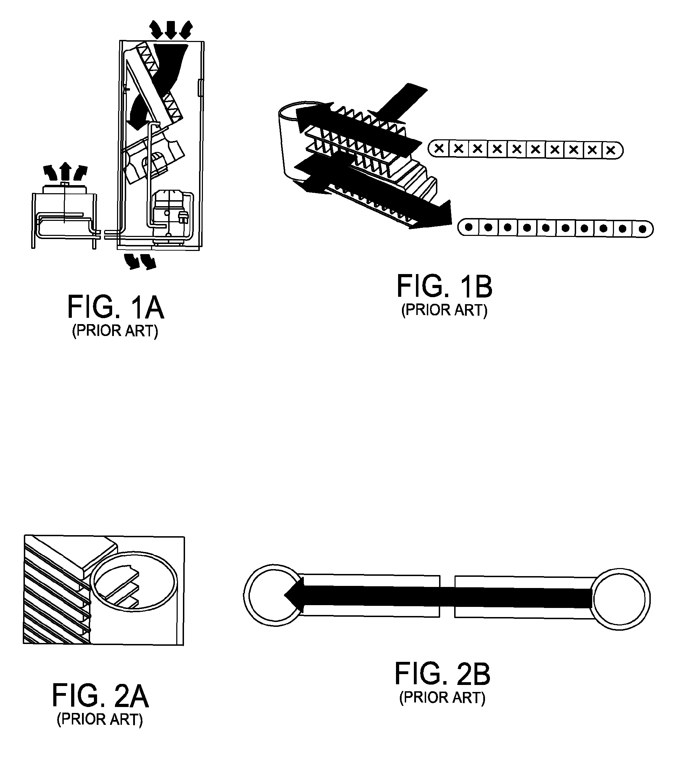

A typical cooling system can include an indoor cooling unit and an outdoor unit, both equipped with a heat exchanger. With the indoor unit, the heat load is absorbed from the air by an evaporator or by a chilled water coil, such as an air-to-water or air-to-refrigerant heat exchanger, and transferred to the external ambient in a condenser or dry-cooler, such as a refrigerant-to-air or water-to-air heat exchanger. The heat exchangers can include micro-channel coils, which are illustrated in FIGS. 1A and 1B. With current micro-channel coil technology, a fluid path is generally one way through the micro-channels. Referring to FIGS. 2A and 2B, this configuration includes left and right cylinders as manifolds with micro-channel coils extending between the manifolds, which enable fluid flow in only one direction.

SUMMARY OF THE DISCLOSURE

One aspect of the present disclosure is directed to a cooling unit comprising a heat exchanger coil positioned coupled to a source of fluid. In one embodiment, the heat exchanger includes at least one coil configured to face air being drawn through the heat exchanger. The at least one coil has a first pipe, a second pipe spaced from the first pipe, and a plurality of micro-channels disposed between and in fluid communication with the first pipe and the second pipe. Each of the first pipe, the second pipe and the plurality of micro-channels is configured to enable a countercurrent configuration between inner and outer fluids.

Embodiments of the cooling unit further may include configuring at least one of the first pipe and the second pipe with a cylindrical wall having an inner bifurcating wall positioned within the cylindrical wall to create a first fluid passage that forms a first part of the circuit and a second fluid passage that forms a second part of the circuit. Each micro-channel of the plurality of micro-channels may include an outer wall having a plurality of inner walls positioned within the outer wall to create a first fluid passage that forms a first part of the circuit and a second fluid passage that forms a second part of the circuit. At least one of the first pipe and the second pipe, and the plurality of micro-channels each may be configured with an outer wall having an inner bifurcating wall positioned within the cylindrical wall to create a first fluid passage that forms a first part of the circuit and a second fluid passage that forms a second part of the circuit. Fluid may enter the first pipe through an inlet side of the first pipe and may flow through a first portion of the micro-channel to the second pipe. Fluid may flow through a second portion of the micro-channel back to an outlet side of the first pipe.

Another aspect of the present disclosure is directed to a cooling unit comprising a heat exchanger positioned coupled to a source of fluid. In one embodiment, the heat exchanger includes a coil having a first part of a circuit to transfer fluid in a first direction and a second part of the circuit to transfer fluid in a second direction opposite to the first direction.

Embodiments of the cooling unit further may include configuring the coil of the heat exchanger with an inlet pipe, a transfer pipe, and a micro-channel that extends between the inlet pipe and the transfer pipe. The inlet pipe may include an outer cylindrical wall and a middle longitudinal wall positioned within the cylindrical wall to define an inlet side of the inlet pipe and an outlet side of the inlet pipe. Fluid may enter the inlet pipe through the inlet side of the inlet pipe and may flow through a first portion of the micro-channel to the transfer pipe. Fluid may flow through a second portion of the micro-channel back to the inlet pipe to the outlet side of the inlet pipe. Fluid flowing from the inlet side of the inlet pipe through the first portion of the micro-channel to the transfer pipe may define the first part of the circuit and fluid flowing from the transfer pipe through the second portion of the micro-channel to the outlet side of the inlet pipe can defines the second part of the circuit. The first portion of the micro-channel may include several interior walls to define a plurality of inlet channels and the second portion of the micro-channel may include several interior walls to define a plurality of outlet channels. Each micro-channel further may include several fins that absorb heat from warm air flowing toward the coil of the heat exchanger thereby evaporating or condensing the liquid fluid flowing through the micro-channel.

Yet another aspect of the present disclosure is directed to a method of cooling comprising: positioning a cooling unit in a data center; drawing relatively warm air into the cooling unit; moving the warm air over a heat exchanger of the cooling unit and coupled to a source of fluid; and directing fluid within a micro-channel coil of the heat exchanger through a first part of a circuit to transfer fluid in a first direction and through a second part of the circuit to transfer fluid in a second direction opposite to the first direction.

Embodiments of the method further may include moving fluid through the inlet side of the inlet pipe and through a first portion of the several micro-channels to the transfer pipe. The method further may include moving fluid from the transfer pipe through a second portion of the several micro-channels back to the outlet side of the inlet pipe. Fluid flowing from the inlet side of the inlet pipe through the first portion of the several micro-channels to the transfer pipe may define the first part of the circuit and fluid flowing from the transfer pipe through the second portion of the several micro-channels to the outlet side of the inlet pipe can defines the second part of the circuit. The first portion of the several micro-channels may include several interior walls to define a plurality of inlet channels and the second portion of the several micro-channels may include several interior walls to define a plurality of outlet channels. Each micro-channel further may include several fins that absorb heat from warm air flowing toward the micro-channel coil thereby evaporating or condensing the fluid flowing through the several micro-channels. The micro-channel coil may include an inlet pipe, a transfer pipe, and several micro-channels that extend between the inlet pipe and the transfer pipe.

BRIEF DESCRIPTION OF THE DRAWINGS

In the drawings, each identical or nearly identical component that is illustrated in various figures is represented by a like numeral. For purposes of clarity, not every component may be labeled in every drawing. For a better understanding of the present disclosure, reference is made to the figures which are incorporated herein by reference and in which:

FIG. 1A is a schematic view of a condenser and evaporator heat exchangers within a housing of a cooling unit of a prior art embodiment;

FIG. 1B is an enlarged schematic perspective view of a portion of an evaporator coil shown in FIG. 1, showing prior art micro-channel coils;

FIG. 2A is an enlarged perspective view of a portion of a heat exchanger of another prior art embodiment, showing a manifold in fluid configurations with the micro-channels;

FIG. 2B is a schematic view of the heat exchanger shown in FIG. 2A, showing fluid flow through the coil;

FIG. 3A is a schematic representation of a concurrent flow system and a graph showing a temperature profile of fluid flow within the concurrent flow system;

FIG. 3B is a schematic representation of a countercurrent flow system and a graph showing a temperature profile of fluid flow within the countercurrent flow system;

FIG. 4 is a schematic view of a portion of a heat exchanger having a countercurrent circuit of an embodiment of the disclosure;

FIG. 5 is a schematic view of another portion of the heat exchanger having the countercurrent circuit, showing fluid flow within and airflow over the heat exchanger;

FIG. 6 is a schematic view of a portion of a heat exchanger having a countercurrent circuit of another embodiment of the disclosure;

FIG. 7 is a graph showing a vapor compression cycle of a heat exchanger of embodiments of the disclosure;

FIG. 8 is a schematic view of a portion of a heat exchanger having a countercurrent circuit of another embodiment of the disclosure;

FIG. 9 is a schematic view of a portion of a heat exchanger having a countercurrent circuit of another embodiment of the disclosure; and

FIG. 10 is a schematic view of a portion of a heat exchanger having a countercurrent circuit of another embodiment of the disclosure.

## DETAILED DESCRIPTION OF THE PREFERRED EMBODIMENTS

For the purposes of illustration only, and not to limit the generality, the present disclosure will now be described in detail with reference to the accompanying figures. This disclosure is not limited in its application to the details of construction and the arrangement of components set forth in the following description or illustrated in the drawings. The disclosure is capable of other embodiments and of being practiced or being carried out in various ways. Also the phraseology and terminology used herein is for the purpose of description and should not be regarded as limiting. The use of "including," "comprising," "having," "containing," "involving," and variations thereof herein, is meant to encompass the items listed thereafter and equivalents thereof as well as additional items.

Data centers are typically large rooms designed, in certain instances, to house hundreds of electronic equipment racks arranged in rows within the data center. The rows of equipment racks can be arranged in such a manner that there are cold aisles and hot aisles. The cold aisles provide access to the fronts of the enclosures where the electronic equipment is typically accessed. The hot aisles provide access to the backs of the equipment racks. As requirements change, the number of equipment racks may be increased or decreased depending on the functional requirements of the data center. A cooling unit of an embodiment of the present disclosure includes countercurrent configuration within a micro-channel coil of a heat exchanger of the cooling unit to increase efficiency.

In one embodiment, each cooling unit has a housing that is configured to support components of the cooling system within the housing. For example, the components of the cooling unit may include a heat exchanger embodying an evaporator that is coupled to a source of liquid refrigerant, such as R-410A or R-134a refrigerants, which can be referred to as fluid. The evaporator is connected to the source so that liquid refrigerant (or partially vaporized refrigerant) is delivered to the evaporator and vaporized refrigerant is returned to the source (as in a vapor compression cycle). Other units, sometimes referred to as "fan coils," include a heat exchanger embodying a chilled water coil supplied by chilled water or glycol mixtures provided by external chillers, dry coolers or cooling towers. The cooling unit may further include one or more fan modules to move air across the heat exchanger. The cooling unit may be disposed within a row of equipment racks and configured to intake the hot air within the data center from a hot aisle, for example, to cool the air to slightly below ambient temperature. This configuration eliminates the inefficiency of mixing hot air with the room temperature air to obtain a warm mixture.

The cooling system of embodiments of the present disclosure is capable of employing one or more cooling units on an as needed basis to provide localized cooling within the data center. Specifically, multiple cooling units may be placed anywhere within the data center, including being interspersed in a row of equipment racks to more efficiently cool the data center. The circulation path of warm air generated by the electronic equipment is greatly reduced, thereby nearly eliminating the mixing of hot and cold air within the data center.

In certain embodiments, the cooling unit may be one-half the width of a standard size nineteen inch equipment rack, e.g., twelve inches in width, and may be modular so that the cooling unit may be inserted into a row of equipment racks. The modular nature of the cooling system allows the user to optimize the location of each cooling unit. Thus, the cooling system may be employed and redeployed for maximum efficiency and use within the data center.

In one embodiment, a heat exchanger of the cooling unit may embody micro-channel coils, which is a ladder-type structure having a pair of larger pipes or manifolds. The pipes are spaced apart from one another with smaller micro-channels extending between the larger pipes. In one example, the arrangement is such that liquid (or partially vaporized) refrigerant enters the heat exchanger by a supply line connected at one end to an inlet and at its other end to a source of liquid refrigerant (e.g., condenser units). Once within the heat exchanger of the cooling unit, the liquid refrigerant enters and flows through the micro-channels. The exteriors of the micro-channels have fins that absorb heat from warm air flowing toward the cooling unit thereby evaporating the liquid refrigerant flowing through the micro-channels. The vaporized refrigerant is exhausted into the return line connected at one end to an outlet and at its other end to the source of liquid refrigerant or compressor suction.

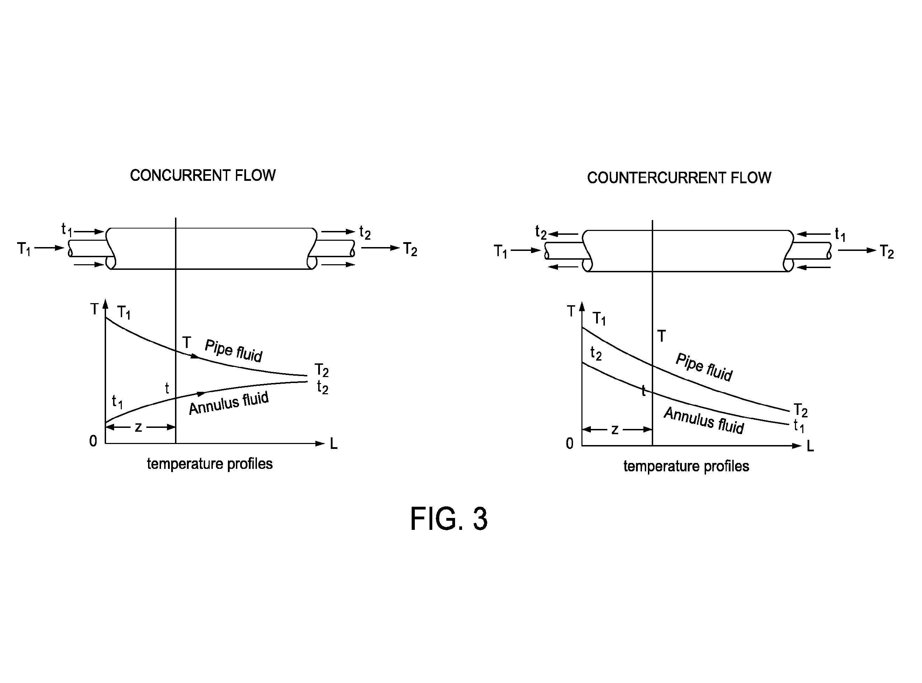

Embodiments of the micro-channel coil include configuring the inlet and transfer pipes and the micro-channel coil with a primary passage to transfer liquid refrigerant in a first direction and a secondary passage to transfer liquid refrigerant in a second direction, which is opposite to the first direction. The benefits of crossing the streams in a heat exchanger can be explained by the following considerations. The heat transfer in flow systems is driven by the temperature difference between the streams. This concept can be easily explained starting from double pipe heat exchangers. FIG. 3A illustrates a schematic representation and a graph showing a temperature profile of fluid flow within a concurrent flow system. FIG. 3B illustrates a schematic representation and a graph showing a temperature profile of fluid flow within a countercurrent flow system. In every section (z) of a double pipe heat exchanger, the heat transfer is proportional to temperature difference between the pipe and the annulus fluid. This heat transfer is represented by the following equation.

$$q = U * A * (t' - t'') \qquad (1)$$

Where:

$q$ = exchanged heat,
$U$ = heat transfer coefficient,
$A$ = exchange area,
$t'$ = pipe fluid temperature, and
$t''$ = annulus fluid temperature.

By integrating from the beginning to the end of the heat exchanger, the total heat exchange results -

$$Q = U * Ar * LMTD \qquad (2)$$

Where:

$U$ = heat transfer coefficient,
$Ar$ = total area of the exchanger, and
$LMTD$ (Logarithmic Mean Temperature Difference) = a logarithmic average of the temperature difference between the hot and cold streams at each end of the exchanger (under constant flow rate and fluid thermal properties).

The larger the LMTD, the more heat is transferred. The Logarithmic Mean Temperature Difference is define by the following equation -

$$LMTD = \frac{\Delta T_A - \Delta T_B}{in\ (\Delta T_A / \Delta T_B)} \qquad (3)$$

Where:

$\Delta T_A$ = fluids temperature difference at one side of the exchanger, and
$\Delta T_B$ = fluids temperature difference at the opposite side of the exchanger.

On equal inlet temperatures, the countercurrent LMTD value is always greater than the concurrent one. The countercurrent LMTD value is equal to the concurrent one only in case one of the fluid evolves at constant temperature (T_in=T_out).

With the micro-channel coil heat exchanger of embodiments of the present disclosure, in which the flow configuration cannot be either assimilated to a perfect countercurrent or concurrent one, the heat transfer can be calculated by the following equation -

$$Q = U * Ar * \underline{DT} \qquad (4)$$

Where:

$\underline{DT}$ = the average effective temperature difference between the fluids.

$\underline{DT}$ is defined by the following equation -

$$\underline{DT} = F_t * LMTD_{cc} \qquad (5)$$

Where:

$LMTD_{cc}$ = the Logarithmic Mean Temperature Difference in a countercurrent flow configuration, and
$Ft$ factor (<1) = the distance of the exchanger configuration taken in account from the perfect countercurrent one.

Fixing the heat transfer coefficient and the exchange area, one way to improve the exchanged heat is increasing the $LMDT$ value. The way to improve the $LMDT$ value is to move to an ideal countercurrent flow arrangement.

Moving to a countercurrent flow arrangement is described herein with reference to the following drawings.

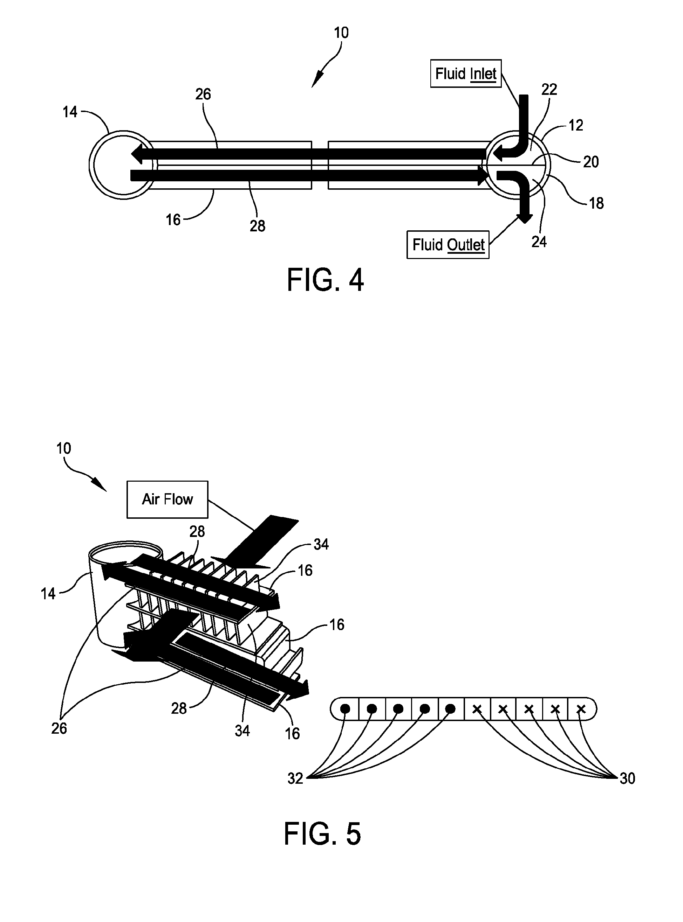

Referring to FIG. 4, a portion of a coil, e.g., an evaporator, generally indicated at 10, includes a countercurrent configuration of an embodiment of the disclosure. As shown, the coil 10 includes an inlet pipe or manifold 12, a transfer pipe or manifold 14, and a micro-channel 16 that extends between the inlet pipe and the transfer pipe. In one embodiment, the inlet pipe 12 includes an outer cylindrical wall 18 and a middle longitudinal wall or septum 20 positioned within the cylindrical wall. The middle wall 20 bifurcates the inlet pipe 12 so that one half of the inlet pipe defines an inlet side 22 of the inlet pipe and the other half of the inlet pipe defines an outlet side 24 of the inlet pipe, and returned to the source of fluid, e.g., by a compressor inlet.

The arrangement is such that fluid enters the inlet pipe 12 through the inlet side 22 of the inlet pipe and travels through a portion of the micro-channel 16 to the transfer pipe 14. Once in the transfer pipe 14, the fluid travels through another portion of the micro-channel coil 16 back to the inlet pipe 12 to the outlet side 24 of the inlet pipe. In this embodiment, the fluid that travels from the inlet side 22 of the inlet pipe 12 through the portion of the micro-channel 16 to the transfer pipe 14 can be considered a first passage 26. Similarly, the fluid that travels from the transfer pipe 14 through the other portion of the micro-channel 16 to the outlet side 24 of the inlet pipe 12 can be considered a second passage 28. Thus, the first passage 26 functions to transfer fluid in a first direction. The second passage 28 functions to transfer fluid in a second direction, which is opposite to the first direction.

Referring to FIG. 5, another portion of the coil 10 having the countercurrent configuration illustrates fluid flow within the coil and airflow over the coil. As shown, each micro-channel 16 includes several interior walls to define five inlet channels, each indicated at 30, and five outlet channels, each indicated at 32, through the micro-channel. Each micro-channel 16 further includes several fins, each indicated at 34, that absorb heat from warm air flowing toward the coil 10 thereby evaporating the fluid flowing through the micro-channel. Thus, in one embodiment, fluid enters each micro-channel 16 through five inlet channels 30 of the micro-channel from the inlet side 22 of the inlet pipe 12 and leaves the micro-channel through five outlet channels 32 of the micro-channel from the transfer pipe 14. Thus, with the middle wall 20 within the inlet pipe 12, it is possible to have a bi- or two-directional flow within the micro-channel 16, thereby defining the first passage 26 and the second passage 28.

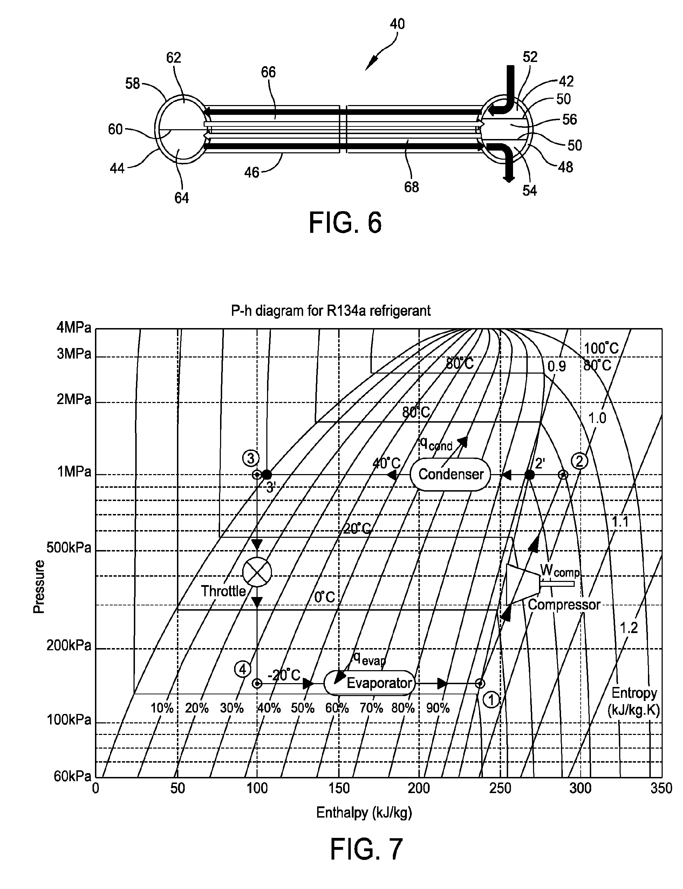

Referring to FIG. 6, by configuring the number and position of the walls, it is possible to increase the number of passes in every single channel. As shown, a portion of another coil, generally indicated at 40, includes four passages in every single micro-channel. As shown, the coil 40 includes an inlet pipe 42, a transfer pipe 44, and a micro-channel 46 that extends between the inlet pipe and the transfer pipe. The inlet pipe 42 includes an outer cylindrical wall 48 and two inner walls, each indicated at 50, positioned within the cylindrical wall. The middle walls 50 separate the inlet pipe 42 so that it is divided in three fluid channels, including an inlet channel 52 provided on one side of the inlet pipe, an outlet channel 54 provided on another side of the inlet pipe, and a middle channel 56 provided between the inlet channel and the outlet channel.

The transfer pipe 44 includes an outer cylindrical wall 58 and a middle longitudinal wall or septum 60 positioned within the cylindrical wall. The middle wall 60 bifurcates the transfer pipe 44 so that one half of the transfer pipe defines a first transfer side of 62 the transfer pipe and the other half of the transfer pipe defines a second transfer side 64 of the transfer pipe.

The arrangement is such that fluid enters the inlet pipe 42 through the inlet channel 52 of the inlet pipe and travels through a portion of the micro-channel 46 to the first transfer side 62 of the transfer pipe 44. Once in the first transfer side 62 of the transfer pipe 44, the fluid travels through another portion of the micro-channel 46 back to the middle channel 56 of the inlet pipe 42, and back to the second transfer side 64 of the transfer pipe 44 through another portion of the micro-channel 46. Once in the second transfer side 64 of the transfer pipe 44, the fluid travels through another portion of the micro-channel 46 back to the outlet channel 54 of the inlet pipe 42 and returned to the source of fluid, e.g., compressor suction.

In this embodiment, the fluid that travels from the inlet channel 52 of the inlet pipe 42 through the portion of the micro-channel 46 to the transfer pipe 44 and back to the middle channel 56 of the inlet pipe through the other portion of the micro-channel can be considered a first passage 66. As shown, the first passage 66 has two legs defining a separate, opposite flow directions. Similarly, the fluid that travels from the middle channel 56 of the inlet pipe 42 through the other portion of the micro-channel 46 to the transfer pipe 44 and back to the outlet channel 54 of the inlet pipe through the other portion of the micro-channel can be considered a second passage 68. In this embodiment, the raising up of pressure drops of the fluid in the first passage 66 and the second passage 68, due to longer circuits, can be reduced by the different cross sectional area and the length of the micro-channels 46.

Referring to FIG. 7, when using micro-channels having a countercurrent passage of embodiments of the disclosure in a condenser (a high pressure heat exchanger in a refrigerant circuit, based on a vapor compression cycle), the fluid at the inlet of the heat exchanger is superheated vapor coming from the compressor (point 2). When the superheated vapor crosses the condenser (from point 2 to point 3), the vapor fluid is de-superheated down to saturated condition on right side of the bell (point 2'). Next, the condensing phase occurs till the other side of the bell (saturated liquid, point 3') and the last section of the circuit is used to sub-cool the liquid till point 3.

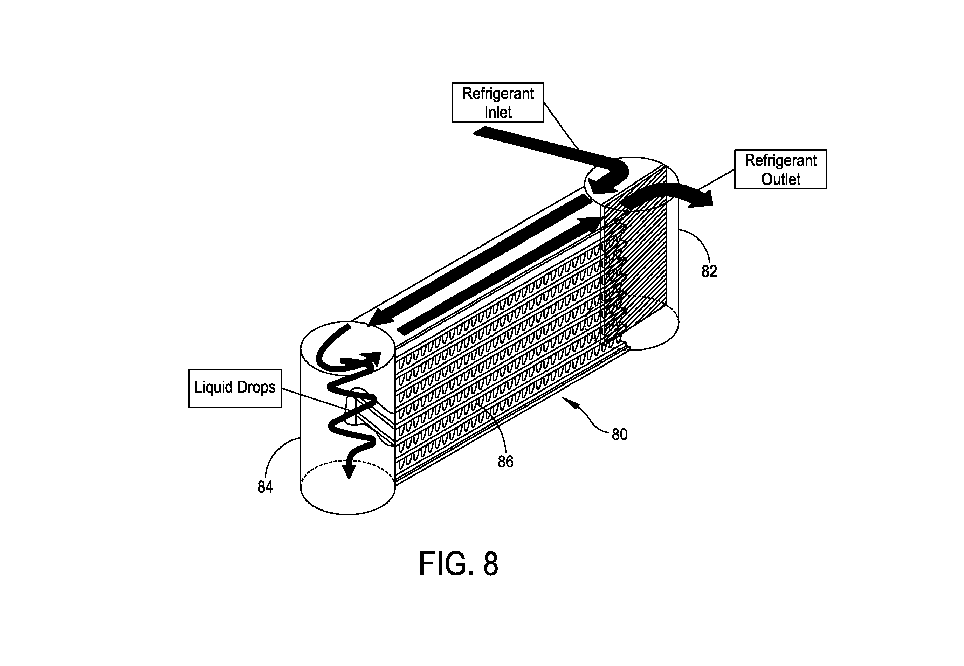

Referring to FIG. 8, a portion of a condenser coil, generally indicated at 80, includes a countercurrent passage of an embodiment of the disclosure. As shown, the condenser coil 80 includes an inlet pipe 82, a transfer pipe 84, and a plurality of micro-channels, together indicated at 86, that extend between the inlet pipe and the transfer pipe. As shown, condenser coil 80 is similar in construction to coil 10. In the transfer pipe 94, a fraction of fluid, due to the gravity, may flood a lower part of the coil 80, thereby reducing the heat transfer and causing liquid and oil stagnation. In fact, the refrigerant inside the transfer pipe 84, after a first pass through the coil 80, is in a condensing phase (inside the bell between the point 1 and point 2 of FIG. 7), in which there is a combination of the two phases (liquid and vapor).

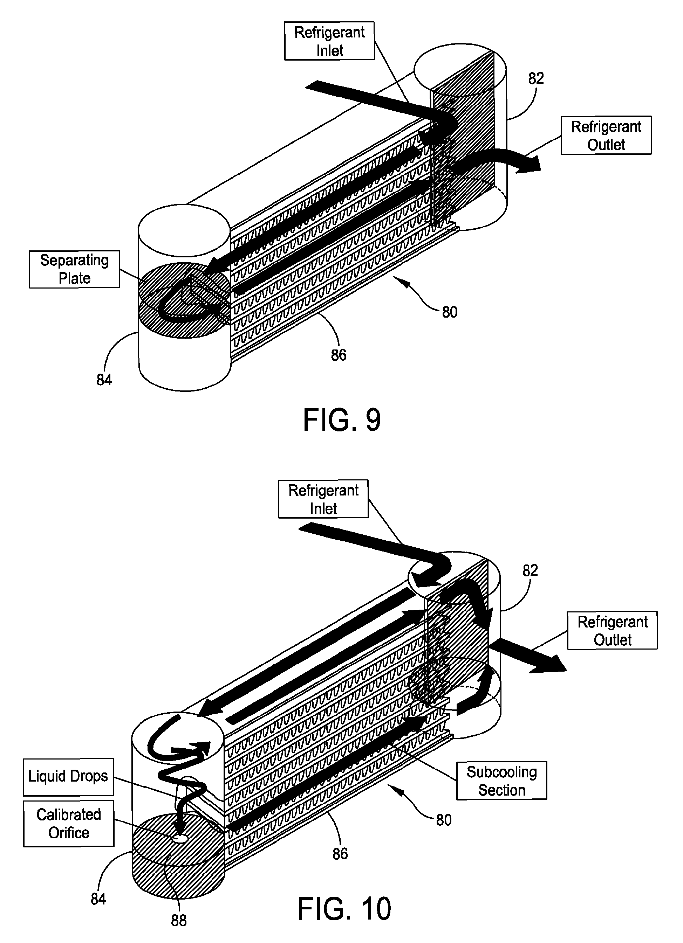

Two different concepts can be applied to solve this issue. Referring to FIG. 9, the first approach is to separate every single circuit on the transfer pipe 84 in order to avoid refrigerant mixing between the micro-channels 86 after a first pass. Referring to FIG. 10, the second approach is to dedicate a lower part of the condenser coil 80 to the fluid. The fluid from the upper part of the transfer pipe 84 is sub-cooled in the dedicated "one passage" micro-channels in the lower part of the micro-channels 86 (sub-cooling section). A separating plate 88 with a calibrated orifice is needed in order to balance the pressure drops of the second passes on the upper condensing section and the pressure drops on the lower sub-cooling section. Separating the liquid after the first pass of the condensing section of the condenser coil 80 improves the condensing phase in a second pass as well as the sub-cooling capability primarily due to the dedicated section.

In some embodiments, the heat exchanger further may include an inlet header, which has the inlet, provided on one side of the heat exchanger. The inlet header may function as a manifold to mix and universally distribute the fluid into the micro-channels provided on the heat exchanger. As the refrigerant travels through the heat exchanger, the fluid becomes a saturated gas and then a superheated gas by the time it reaches an outlet header provided at the other side of the heat exchanger. The outlet header includes the outlet, which is connected to the return line to return the superheated gas to the compressor suction.

In this embodiment, fluid entering the left-hand side of the heat exchanger is gradually heated as the fluid travels up through the heat exchanger toward the outlet header. The evaporated two-phase fluid travels to the other side of the heat exchanger and is super heated as the fluid travels near the outlet header. Thus, the resultant temperature of air travelling through the heat exchanger by each fan is substantially uniform across the width of the cooling unit.

In certain embodiments, a controller may be employed to control the operation of the cooling system, and specifically, in certain embodiments, the operation of the cooling unit. In one embodiment, the controller may be a dedicated unit to the cooling system. In another embodiment, the controller may be provided as part of an integrated data center control and monitoring system. In yet another embodiment, each cooling unit may be independently operable by a controller provided in the cooling unit that is in communication with controllers of the other cooling units. Notwithstanding the particular configuration, the controller is designed to control the independent operation of the cooling unit within the data center.

For example, the controller may be configured to identify the failure or inability of the particular cooling unit to cool the air, and to increase the cooling capacity of the cooling unit or cooling units located near the failed cooling unit. In another embodiment, one cooling unit may operate as the main or master unit and the other cooling units operate as subservient units that operate under the control of the main unit. In this embodiment, the main cooling unit may be manipulated by the data center operator to control the entire cooling system. For example, the controller may be configured to receive information from the equipment racks so as to determine the amount of power being drawn by each equipment rack. With this knowledge, the controller may be configured to increase the cooling capacity of certain cooling units within the cooling system based on the energy drawn by the equipment racks.

In one embodiment, the controller may embody only controller unit provided in the cooling units that communicate with one another over a controller area network (CAN) Bus. In other embodiments, a master controller may be provided to control the operation of the controller units. Changes to the environmental conditions, such as the temperature of the data center, results in changes of inputs including the temperature of the fluid flowing into and out of the cooling unit.

Embodiments of the present disclosure are directed to configuring the heat exchanger to create a countercurrent. In addition, when compared to a conventional tube-fin coil, a micro-channel heat exchanger of embodiments of the disclosure performs high heat transfer efficiency at a compact size. The advantage of the micro-channel heat exchanger enables a relatively large cooling capacity within a limited space.

Due to high overall heat transfer coefficient, the micro-channel heat exchanger is made in less rows and lower fin density as compared to a conventional tube-fin coil. Airflow static pressure differential across the heat exchanger is significantly reduced. The fan units enable large airflow rate and small static pressure lift.

The fan units may be designed to minimize external fan noise, and relieve airflow discharge strength to ceiling. The fan units may be arranged in a two by three column, which optimizes the balance between number of fan units and airflow uniformity on coil surfaces of the heat exchangers.

Having thus described at least one embodiment of the present disclosure, various alternations, modifications and improvements will readily occur to those skilled in the art. Such alterations, modifications and improvements are intended to be within the scope of the disclosure. Accordingly, the foregoing description is by way of example only and is not intended to be limiting. The disclosure's limit is defined only in the following claims and equivalents thereto.

**Claims**

1. A cooling unit comprising:

   a heat exchanger positioned coupled to a source of fluid, the heat exchanger including a coil having a first part of a circuit to transfer fluid in a first direction and a second part of the circuit to transfer fluid in a second direction opposite to the first direction.

2. The cooling unit of claim 1, wherein the coil of the heat exchanger includes an inlet pipe, a transfer pipe, and a micro-channel that extends between the inlet pipe and the transfer pipe.

3. The cooling unit of claim 2, wherein the inlet pipe includes an outer cylindrical wall and a middle longitudinal wall positioned within the cylindrical wall to define an inlet side of the inlet pipe and an outlet side of the inlet pipe.

4. The cooling unit of claim 3, wherein fluid enters the inlet pipe through the inlet side of the inlet pipe and flows through a first portion of the micro-channel to the transfer pipe.

5. The cooling unit of claim 4, wherein fluid flows through a second portion of the micro-channel back to the inlet pipe to the outlet side of the inlet pipe.

6. The cooling unit of claim 5, wherein fluid flowing from the inlet side of the inlet pipe through the first portion of the micro-channel to the transfer pipe defines the first part of the circuit and fluid flowing from the transfer pipe through the second portion of the micro-channel to the outlet side of the inlet pipe defines the second part of the circuit.

7. The cooling unit of claim 5 or 6, wherein the first portion of the micro-channel includes several interior walls to define a plurality of inlet channels and the second portion of the micro-channel includes several interior walls to define a plurality of outlet channels.

8. The cooling unit of claim 5, 6 or 7, wherein the micro-channel further includes several fins that absorb heat from warm air flowing toward the coil of the heat exchanger thereby evaporating or condensing the liquid fluid flowing through the micro-channel.

9. A method of cooling comprising:

positioning a cooling unit in a data center;

drawing relatively warm air into the cooling unit;

moving the warm air over a heat exchanger of the cooling unit and coupled to a source of fluid; and

directing fluid within a micro-channel coil of the heat exchanger through a first part of a circuit to transfer fluid in a first direction and through a second part of the circuit to transfer fluid in a second direction opposite to the first direction.

10. The method of claim 9, wherein the micro-channel coil includes an inlet pipe, a transfer pipe, and several micro-channels that extend between the inlet pipe and the transfer pipe.

11. The method of claim 10, further comprising moving fluid through the inlet side of the inlet pipe and through a first portion of the several micro-channels to the transfer pipe.

12. The method of claim 11, further comprising moving fluid from the transfer pipe through a second portion of the several micro-channels back to an outlet side of the inlet pipe.

13. The method of claim 12, wherein fluid flowing from the inlet side of the inlet pipe through the first portion of the several micro-channels to the transfer pipe defines the first part of the circuit and fluid flowing from the transfer pipe through the second portion of the several micro-channels to the outlet side of the inlet pipe defines the second part of the circuit.

14. The method of claim 12 or 13, wherein the first portion of the several micro-channels includes several interior walls to define a plurality of inlet channels and the second portion of the several micro-channels includes several interior walls to define a plurality of outlet channels.

15. The method of claim 12, 13 or 14, wherein each micro-channel further includes several fins that absorb heat from warm air flowing toward the micro-channel coil thereby evaporating or condensing the fluid flowing through the several micro-channels.

FIG. 1A
(PRIOR ART)

FIG. 1B
(PRIOR ART)

FIG. 2A
(PRIOR ART)

FIG. 2B
(PRIOR ART)

COUNTERCURRENT FLOW

CONCURRENT FLOW

FIG. 3

FIG. 4

FIG. 5

FIG. 6

P-h diagram for R134a refrigerant

FIG. 7

Refrigerant Outlet

Refrigerant Inlet

Liquid Drops

82

80

86

84

FIG. 8

Refrigerant
Inlet

82

Refrigerant
Outlet

Separating
Plate

80

84

86

## FIG. 9

Refrigerant
Inlet

82

Refrigerant
Outlet

Subcooling
Section

Liquid Drops

Calibrated
Orifice

80

84

86

88

## FIG. 10

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/211743 A1 (SCHRADER TIMOTHY J [US] ET AL) 27 August 2009 (2009-08-27) * paragraphs [0004], [0044], [0069] * * paragraphs [0070], [0077]; figures 1,14A * | 1-15 | INV. H05K7/20 F28D1/053 |
|   | ----- |   |   |
| A | JP 2004 225961 A (DENSO CORP) 12 August 2004 (2004-08-12) * figure 11(a) * | 1-15 |   |
|   | ----- |   |   |

| TECHNICAL FIELDS SEARCHED (IPC) |
|---|
| H05K F28D F28F |

The present search report has been drawn up for all claims

| Place of search | Date of completion of the search | Examiner |
|---|---|---|
| The Hague | 29 November 2016 | Pantelakis, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 17 7340

This annex lists the patent family members relating to the patent documents cited in the above-mentioned European search report.
The members are as contained in the European Patent Office EDP file on
The European Patent Office is in no way liable for these particulars which are merely given for the purpose of information.

29-11-2016

| Patent document cited in search report | Publication date | Patent family member(s) | Publication date |
|---|---|---|---|
| US 2009211743 A1 | 27-08-2009 | CN 202013133 U<br>US 2009211743 A1<br>WO 2009105454 A2 | 19-10-2011<br>27-08-2009<br>27-08-2009 |
| JP 2004225961 A | 12-08-2004 | NONE | |

EPO FORM P0459

For more details about this annex : see Official Journal of the European Patent Office, No. 12/82